(19) Europäisches Patentamt
European Patent Office
Office européen des brevets

(11) **EP 4 672 612 A1**

(12) **EUROPEAN PATENT APPLICATION**

(43) Date of publication:
**31.12.2025 Bulletin 2026/01**

(21) Application number: **25184570.7**

(22) Date of filing: **23.06.2025**

(51) International Patent Classification (IPC):
**H03L 7/08** (2006.01)   **H03L 7/089** (2006.01)
**H03L 7/099** (2006.01)

(52) Cooperative Patent Classification (CPC):
**H03L 7/0995; H03L 7/0802; H03L 7/0891;
H03L 7/0893; H03L 7/0896**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.06.2024 KR 20240082938
25.09.2024 KR 20240130068**

(71) Applicant: **Samsung Electronics Co., Ltd.
Suwon-si, Gyeonggi-do 16677 (KR)**

(72) Inventors:
• **LEE, Kyung Min
16677 Suwon-si (KR)**
• **KIM, Gyu Sik
16677 Suwon-si (KR)**
• **JUNG, Jae Hong
16677 Suwon-si (KR)**
• **KIM, Seung Jin
16677 Suwon-si (KR)**

(74) Representative: **Marks & Clerk LLP
15 Fetter Lane
London EC4A 1BW (GB)**

(54) **PHASE-LOCKED LOOP CIRCUIT**

(57)     Example embodiments are directed to a phase-locked loop (PLL) circuit that includes a reference current generation circuit including a PT-VAR circuit. The PT-VAR circuit generates a compensation current to compensate for process variations, temperature changes, and/or power supply voltage changes in the PLL circuit, and the reference current generation circuit outputs the compensation current as a reference current. The PLL circuit further includes a current digital-to-analog converter (DAC) circuit that converts the reference current into a control current based on a digital code, and a VCO that generates a signal based on the control current. The compensation current is a sum of a first compensation current based on PMOS and NMOS transistors and having a complementary-to-absolute temperature (CTAT) characteristic, a second compensation current based on a PMOS transistor and having a proportional-to-absolute temperature (PTAT) characteristic, and a third compensation current based on an NMOS transistor and having a PTAT characteristic.

**FIG. 7**

**Description**

BACKGROUND

Example embodiments relate to a phase-locked loop (PLL) circuit including a PT-VAR circuit which generates a compensation current that compensates for at least one of process variations, temperature fluctuations, and power supply voltage changes in the PLL circuit.

A System-on-Chip (SoC) may use different frequency bands for embedded components therein. To support various frequency bands, the SoC may include a plurality of PLL circuits. A PLL circuit synchronizes data transmission between a synchronous semiconductor device and an external device by using an internal clock signal locked in synchronization with an external clock signal input from the external device. The time synchronization between a reference clock signal and data is advantageous for reliable data transmission between the synchronous semiconductor device and the external device.

A ring-type voltage-controlled oscillator (VCO) may be used in a low-noise, low-power PLL circuit.

SUMMARY

Example embodiments are directed to a PLL circuit that may be relatively less affected by process variations, power supply voltage changes, and/or temperature fluctuations.

Example embodiments are directed to a PLL circuit that may improve reliability, reduce power consumption, and occupy relative lesser area.

However, example embodiments are not restricted to those set forth herein. The above and other aspects of the present disclosure will become more apparent to one of ordinary skill in the art to which the present disclosure pertains by referencing the detailed description of the present disclosure given below.

According to some example embodiments, a PLL circuit includes a reference current generation circuit including a PT-VAR circuit. The PT-VAR circuit is configured to generate a compensation current to compensate for at least one of process variations, temperature changes, and power supply voltage changes in the PLL circuit, and the reference current generation circuit is configured to output the compensation current as a reference current. The PLL circuit further includes a current digital-to-analog converter (DAC) circuit configured to convert the reference current into a control current based on a digital code, and a voltage-controlled oscillator (VCO) configured to generate a signal based on the control current. The compensation current is a sum of a first compensation current based on PMOS and NMOS transistors and having a complementary-to-absolute temperature (CTAT) characteristic, a second compensation current based on a PMOS transistor and having a proportional-to-absolute temperature (PTAT) characteristic, and a third compensation current based on an NMOS transistor and having a PTAT characteristic.

According to some example embodiments, a PLL circuit includes a reference current generation circuit including a PT-VAR circuit. The PT-VAR circuit is configured to generate a compensation current to compensate for at least one of process variations, temperature changes, and power supply voltage changes in the PLL circuit, and the reference current generation circuit is configured to output the compensation current as a reference current. The PLL circuit further includes a current digital-to-analog converter (DAC) circuit configured to convert the reference current into a control current based on a digital code, and a voltage-controlled oscillator (VCO) configured to generate a signal based on the control current. The PT-VAR circuit includes a 3-input amplifier including a first input terminal, a second input terminal, and a third input terminal, a first PMOS transistor connected as a diode between the first input terminal and a power ground terminal, a first NMOS transistor connected as a diode between the second input terminal and the power ground terminal, and a first resistor connected between the third input terminal and the power ground terminal.

According to some example embodiments, a PLL circuit includes a PT-VAR circuit configured to generate a compensation current that compensates for at least one of process variations, temperature changes, and power supply voltage changes in the PLL circuit. The PT-VAR circuit includes a 3-input amplifier including a first input terminal, a second input terminal, and a third input terminal, a first PMOS transistor connected as a diode between the first input terminal and a power ground terminal, a first NMOS transistor connected as a diode between the second input terminal and the power ground terminal, a first resistor connected between the third input terminal and the power ground terminal, a second PMOS transistor connected as a diode between the third input terminal and the power ground terminal, and a second NMOS transistor connected as a diode between the third input terminal and the power ground terminal. The compensation current is a sum of a first compensation current flowing through the first resistor and having a complementary-to-absolute temperature (CTAT) characteristic, a second compensation current flowing through the second PMOS transistor and having a proportional-to-absolute temperature (PTAT) characteristic, and a third compensation current flowing through the second NMOS transistor and having a PTAT characteristic.

It should be noted that the technical effects of the example embodiments are not limited to those described above, and other technical effects will be apparent from the following description.

At least some of the above and other features of the invention are set out in the claims.

BRIEF DESCRIPTION OF THE DRAWINGS

The above and other aspects and features of the present disclosure will become more apparent by describing in detail example embodiments thereof with reference to the attached drawings, in which:

FIG. 1 is a circuit diagram of a ring oscillator.
FIG. 2 is a circuit diagram of a delay cell of FIG. 1.
FIG. 3 is a circuit diagram of a PLL circuit.
FIG. 4 is a graph showing the frequency generation values of a ring oscillator according to a control voltage.
FIG. 5 is a circuit diagram of a PLL circuit.
FIG. 6 is a circuit diagram of a PT-VAR circuit.
FIG. 7 is a circuit diagram of a PT-VAR circuit.
FIG. 8 is a circuit diagram of an amplifier of FIG. 7.
FIG. 9 is a circuit diagram of a PLL circuit including the PT-VAR circuit of FIG. 7.

DETAILED DESCRIPTION

As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C," "at least one of A, B, or C") may be construed as A only, B only, C only, or any combination of two or more of A, B, and C, such as, for instance, ABC, AB, BC, and AC.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

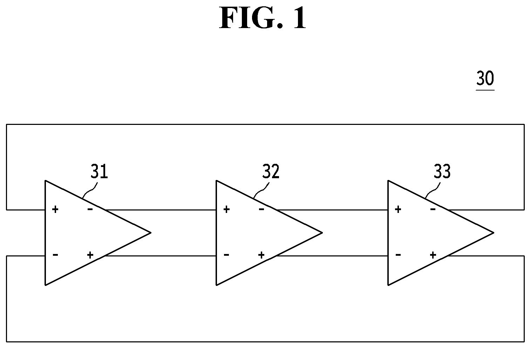

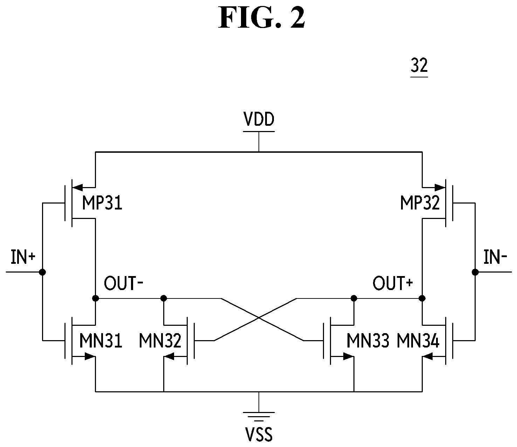

FIG. 1 is a circuit diagram of a ring oscillator. FIG. 2 is a circuit diagram of a delay cell of FIG. 1.

Referring to FIGS. 1 and 2, a ring oscillator 30 may be configured with three stages and may include first, second, and third delay cells 31, 32, and 33. To more effectively reduce or minimize common mode noise, the signal paths between the first, second, and third delay cells 31, 32, and 33 may be implemented as differential paths.

Each of the first, second, and third delay cells 31, 32, and 33 may include NMOS transistors and PMOS transistors. For example, the second delay cell 32 may include a pair of PMOS transistors MP31 and MP32 and a pair of NMOS transistors MN31 and MN34, which receive an input voltage and output an output voltage, and a pair of NMOS transistors MN32 and MN33, which are connected via cross-coupling. The PMOS transistors MP31 and MP32 and the NMOS transistors MN31 and MN34 may receive differential input voltages IN+ and IN- at their gates and output differential output voltages OUT- and OUT+ to common drain nodes MP31-MN31 and MP32-MN34 of the PMOS transistors MP31 and MP32 and the NMOS transistors MN31 and MN34. The source of the NMOS transistors MN32 may be connected to the source of the NMOS transistors MN31 and the drain of the NMOS transistors MN32 may be connected to the drain of the NMOS transistors MN31. The source of the NMOS transistors MN33 may be connected to the source of the NMOS transistors MN34 and the drain of the NMOS transistors MN33 may be connected to the drain of the NMOS transistors MN34. The differential output voltages OUT+ and OUT- may be supplied to the gates of the NMOS transistors MN32 and MN33, respectively. The drains of the PMOS transistors MP31 and MP32 may be connected to a power supply voltage VDD and the sources of the NMOS transistors MN31, MN32, MN33, and MN34 may be connected to a power ground terminal VSS.

The differential output signals OUT+ and OUT- may be generated as a pair of periodic sinusoidal signals, and the output signal OUT+ may have a phase difference of 180 degrees from the output signal OUT-. The differential output signals OUT+ and OUT- may be converted to single-ended signals, and any common mode noise injected into an input terminal or a power supply terminal may be reduced or minimized.

The second delay cell 32 may adjust a frequency thereof based on a transconductance $g_m$ and the load capacitance of the PMOS transistors MP31 and MP32 and the NMOS transistors MN31 and MN34. The transconductance of the PMOS transistors MP31 and MP32 and the NMOS transistors MN31 and MN34 may be adjusted through a reference current, and may have a relatively wider frequency tuning range depending on the adjusted transconductance.

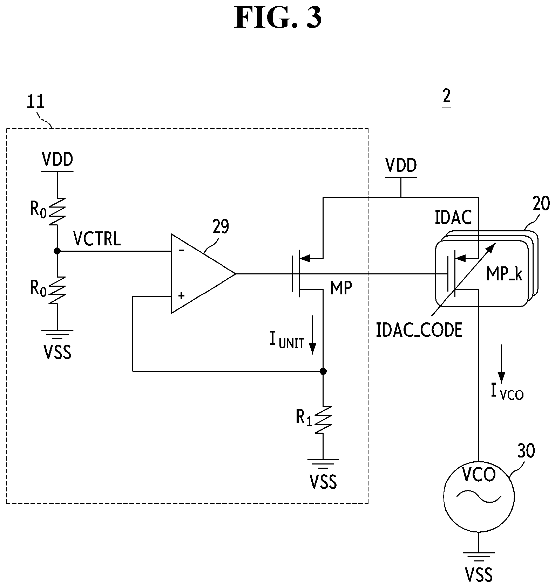

FIG. 3 is a circuit diagram of a PLL circuit.

Referring to FIG. 3, a PLL circuit 2 may include a plurality of current digital-to-analog converters (DAC) ("IDAC") 20 and a voltage-controlled oscillator (VCO) 30.

The current DACs 20 may adjust the transconductance of a PMOS transistor MP_k based on a digital code IDAC_Code. For example, the digital code IDAC_Code may turn each of the current DACs 20 on or off, and a reference current $I_{UNIT}$ corresponding to the number of current DACs 20 that are turned on may be supplied to the VCO 30. The current DACs 20 may generate a VCO input current $I_{VCO}$ adjusted by the digital code IDAC_Code based on the reference current $I_{UNIT}$.

The reference current $I_{UNIT}$ may be generated by a reference current generation circuit 11 including an amplifier 29, a PMOS transistor MP, and a plurality of resistors $R_0$ and $R_1$. Resistor $R_0$ is a divided resistance, a control voltage VCTRL (= VDD/2) may be supplied to the negative (-) input terminal of the amplifier 29, while the positive (+) input terminal of the amplifier 29 may be connected to the drain terminal of the PMOS transistor MP, providing a feedback voltage V (= $I_{UNIT} R_1$) based on the reference current $I_{UNIT}$.

The PMOS transistor MP may receive the output voltage of the amplifier at its gate terminal and may generate the reference current $I_{UNIT}$ based on a power supply voltage VDD and the output voltage of the amplifier.

In some example embodiments, the reference current $I_{UNIT}$ may be calculated as shown in Equation 1.

[Equation 1]

$$I_{UNIT} = \frac{VCTRL}{R_1} = \frac{VDD}{2R_1}$$

Referring to Equation 1, the reference current $I_{UNIT}$ may be the value obtained by dividing the control voltage VCTRL by the resistance $R_1$ of a regulation loop, and may be calculated as the voltage obtained by dividing half the power supply voltage VDD by the resistance $R_1$. Since the current DACs 20 are connected to the VCO 30, the VCO input current $I_{VCO}$ supplied to the VCO 30 may be calculated by multiplying the reference current $I_{UNIT}$ by the digital code IDAC_CODE.

However, since transistors may be affected by process variations and the reference current $I_{UNIT}$ that determines transconductance is based on the power supply voltage VDD as shown in Equation 1, frequency deviations due to changes in the power supply voltage VDD may occur. Additionally or alternatively, the resistance $R_1$ of the regulation loop may also vary with temperature due to a temperature coefficient and the threshold voltage of a PMOS transistor.

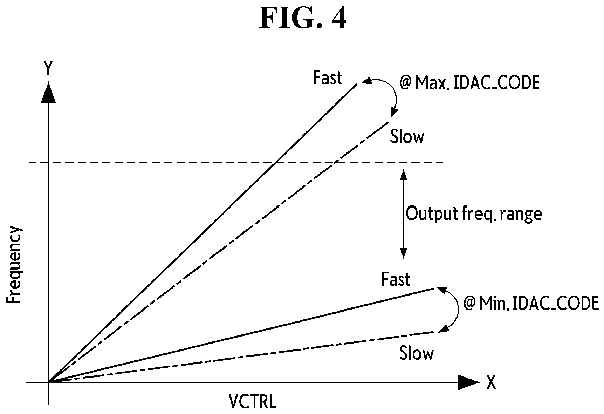

Since the PLL circuit 2 may be sensitive to process variations, changes in the power supply voltage VDD, and/or temperature fluctuations, it may be beneficial to increase the dynamic range of the current DACs 20 in response to these changes to generate signals over a relatively wider frequency band under various conditions. The dynamic range of the current DACs 20 will be discussed later in detail with reference to FIG. 4.

FIG. 4 is a graph showing the frequency generation values of a ring oscillator according to a control voltage.

In order for a PLL circuit to operate relatively consistently in the presence of process variations, power supply voltage changes, and temperature fluctuations (hereinafter referred to as PVT variations), it may be beneficial to increase or optimize the dynamic range of IDACs. The dynamic range of the IDACs may be determined by the bit width of digital signal IDAC_CODE.

In the graph of FIG. 4, the X-axis represents the magnitude of a control voltage, and the Y-axis represents the frequency generation range of a VCO. Referring to FIG. 4, the PLL circuit provides a predefined high or low frequency band. For a predefined (or desired) high frequency, the PLL circuit with a maximum bit width Max.IDAC_CODE of the digital code IDAC_CODE may implement the slope of a slow condition to achieve the predefined (or desired) high frequency. Additionally, or alternatively, for a predefined (or desired) low frequency, the PLL circuit 2 with a minimum bit width Min.IDAC_CODE of the digital code IDAC_CODE may implement the slope of a fast condition to achieve the predefined (or desired) low frequency.

The dynamic range of the digital code IDAC_CODE in the PLL circuit itself may range from the slope of the minimum bit width Min.IDAC_CODE in the fast condition to the slope of the maximum bit width Max.IDAC_CODE in the slow condition, and in order to ensure a reliable (or desired) operation of the PLL circuit in the presence of PVT variations, the bit width of the digital code IDAC_CODE may be increased to broaden the output frequency range.

Since the bit width of the digital code IDAC_CODE is based on the IDACs, increasing the number of IDACs may increase the bit width of the digital code IDAC_CODE. Therefore, it may be beneficial to implement a PLL circuit that operates reliably in presence of PVT variations and has an appropriate (or desired) number of IDACs.

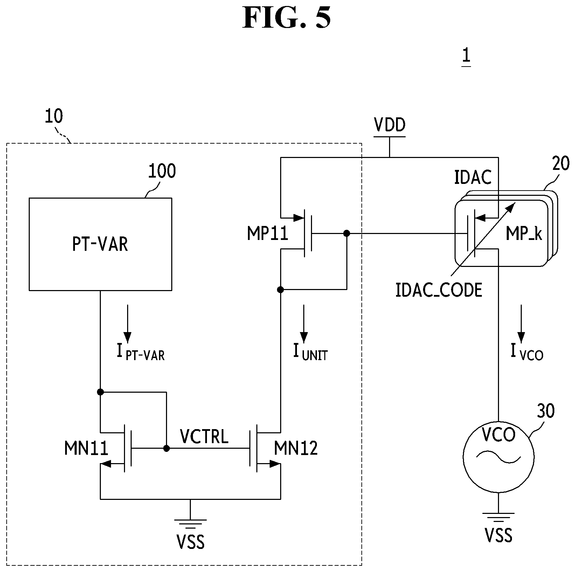

FIG. 5 is a circuit diagram of a PLL circuit 1.

Referring to FIG. 5, a PLL circuit 1 may include a reference current generation circuit 10, current DACs ("IDAC") 20, and a VCO 30. In some example embodiments, the reference current generation circuit 10 may include a PT-VAR circuit ("PT-VAR") 100, a pair of NMOS transistors MN11 and MN12, which form a first current mirror, and a PMOS transistor MP11, which form a second current mirror with the current DACs 20.

The NMOS transistor MN11 may have its drain terminal connected to the PT-VAR circuit 100, and its gate and drain terminals electrically connected. The NMOS transistor MN12 may have its drain terminal connected to the drain terminal of the PMOS transistor MP11, and its gate connected to the gate of the NMOS transistor MN11, thereby being electrically connected to the drain terminal of the NMOS transistor MN11.

A gate control voltage VCTRL for the NMOS transistors MN11 and MN12 may be generated according to a compensation current $I_{PT\text{-}VAR}$ of the PT-VAR circuit 100, and the first current mirror including the NMOS transistors MN11 and MN12 may generate a reference current $I_{UNIT}$ based on the compensation current $I_{PT\text{-}VAR}$ of the PT-VAR circuit 100.

The gate of the PMOS transistor MP11 may be commonly connected to the gate of a PMOS transistor MP_k included in the current IDACs 20, and may be electrically connected to the drain terminal of the PMOS transistor MP11.

According to some example embodiments, the PLL circuit 1 may compensate for PVT variations in the transistors that form circuitry, by generating the gate control voltage VCTRL and the reference current IUNIT based on the compensation current IPT-VAR of the PT-VAR circuit 100.

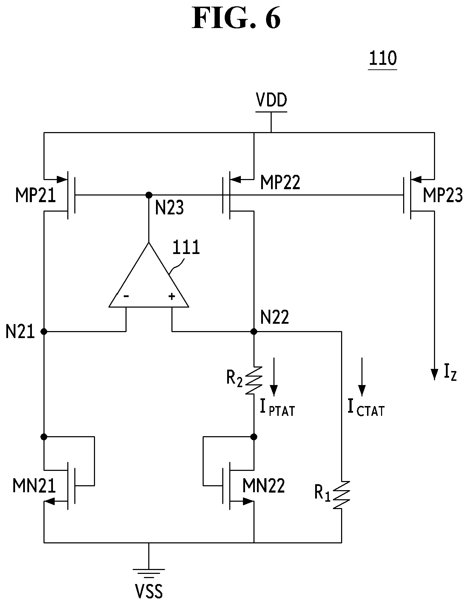

FIG. 6 is a circuit diagram of a PT-VAR circuit 110.

Referring to FIG. 6, the PT-VAR circuit 110 may correspond to the PT-VAR circuit 100 of FIG. 5. The PT-VAR circuit 110 may include an amplifier 111, a pair of NMOS transistors MN21 and MN22, a group of PMOS transistors MP21, MP22, and MP23, and resistors $R_1$ and $R_2$. The NMOS transistors MN21 and MN22 may be connected between a power ground terminal VSS and a node N21, and between a power ground terminal VSS and a node N22, respectively. The NMOS transistors MN21 and MN22 may have their source terminals connected to the power ground terminal VSS, and their drain terminals connected to their gate terminals, forming a diode connection. A gate-source voltage $V_{GS1}$ may be applied to the gate of the NMOS transistor MN21, and a gate-source voltage $V_{GS2}$ may be applied to the gate of the NMOS transistor MN22.

The NMOS transistor MN22 may be connected between the power ground terminal VSS and a first terminal (+) of the amplifier 111, and the NMOS transistor MN21 may be connected between the power ground terminal VSS and a second terminal (-) of the amplifier 111. The resistor $R_2$ may be connected between the NMOS transistor MN22 and a node N22, and the resistor $R_1$ may be connected in parallel with the NMOS transistor MN22 between the power ground terminal VSS and the node N22.

The PMOS transistors MP21 and MP22 may be connected between a node N21 and a power supply terminal VDD, and between the node N22 and the power supply terminal VDD, respectively. The gate terminals of the PMOS transistors MP21, MP22, and MP23 may be connected to an output node N23 of the amplifier 111.

When the NMOS transistor MN21 of the PT-VAR circuit 110 operates in a sub-threshold region, a current $I_{DS\_MN21}$ flowing through the NMOS transistor MN21 may be calculated as shown in Equation 2.

[Equation 2]

$$I_{DS\_MN21} = \mu C_{ox} \frac{W}{L} (\eta - 1) V_T^2 exp^{(\frac{V_{GS1}-V_{th}}{\eta V_T})}$$

Referring to Equation 2, $V_{GS1}$ is the gate-source voltage of the NMOS transistor MN21, $V_{th}$ is the threshold voltage of the NMOS transistor MN21, $\eta$ is the sub-threshold slope factor of the NMOS transistor MN21, T is the absolute temperature, $V_T$ is the thermal voltage proportional to the absolute temperature T (kT/q), $\mu$ is the electron mobility, Cox is the capacitance of the oxide of the NMOS transistor MN21, W is the width of the NMOS transistor MN21, and L is the length of the NMOS transistor MN21.

The diode-connected NMOS transistor MN21 may have a gate-source voltage $V_{GS1}$ with a negative coefficient in the temperature-voltage relationship, and the current $I_{DS\_MN21}$, which is proportional to the voltage gate-source voltage $V_{GS1}$, may be a complementary-to-absolute temperature (CTAT) current with a negative coefficient relative to the absolute temperature T. Additionally, due to process variations, the threshold voltage $V_{th}$ of the NMOS transistor MN21 may change, and process variation information of the corresponding NMOS transistor process can be obtained through the voltage $V_{GS1}$. A CTAT current $I_{CTAT\_N}$ (= $V_{GS1}$ / $R_1$) may flow through the resistor $R_1$, which is connected in parallel with the NMOS transistor MN21, according to the voltage $V_{GS1}$.

The NMOS transistor MN21 may have a different size than the NMOS transistor MN22. The NMOS transistor MN21 may be n times the size of the NMOS transistor MN22. Since different sizes between the NMOS transistors MN21 and MN22 may lead to different temperature characteristics, proportional-to-absolute temperature (PTAT) characteristics may be observed based on the voltage difference between the NMOS transistors MN21 and MN22. A PTAT current $I_{PTAT}$ based on the size difference between the NMOS transistors MN21 and MN22 may be proportional to the absolute temperature T, as shown in Equation 3.

[Equation 3]

$$\Delta V_{GS} = V_{GS1} - V_{GS2} = V_T \ln \frac{nI_{DS1}}{I_{01}} - V_T \ln \frac{I_{DS2}}{I_{02}} = V_T \ln n = \frac{kT}{q} \ln n$$

Referring to Equation 3, $V_{GS2}$ is the gate-source voltage of the NMOS transistor MN22, $V_{GS1}$ is the gate-source voltage of the NMOS transistor MN21, $I_{DS1}$ is the drain-source current of the NMOS transistor MP21, $I_{DS2}$ is the drain-source current of the PMOS transistor MN22, n is the size ratio of the NMOS transistor MN22 to the NMOS transistor MN21, and T is the absolute temperature.

The PTAT current $I_{PTAT}$ based on $\Delta V_{GS}$ may be proportional to the absolute temperature T. The NMOS transistors MN21 and MN22 generate the PTAT current IPTAT (= $\Delta$VGS / R2) based on the resistance R2 and $\Delta$VGS, and the PTAT current IPTAT may be proportional to the absolute temperature T.

A compensation current IZ of the PT-VAR circuit 110 may be generated by summing up the PTAT current IPTAT and the CTAT current ICTAT_N, as shown in Equation 4.

[Equation 4]

$$I_Z = \frac{V_{GS1}}{R_1} + \frac{\Delta V_{GS2}}{R_2} = \frac{1}{R_1}\left(V_{GS1} + \frac{R_1}{R_2}\Delta V_{GS}\right)$$

According to Equation 4, the PT-VAR circuit 110 can output a constant current regardless of temperature changes by adjusting the ratio of the resistors R1 and R2.

Additionally, the gate-source voltage $V_{GS1}$ of the NMOS transistor MN21 may change due to process variations in the corresponding NMOS transistor process, and information regarding the process variations can be acquired from the resulting varying current, allowing the process variations to be compensated for. However, in a typical VCO, both NMOS transistors and PMOS transistors are affected by process variations, and a PT-VAR circuit 110 designed with NMOS transistors and a PT-VAR circuit 110 designed with PMOS transistors may be configured or designed in order to compensate for a VCO in a desired manner. Therefore, two types of PT-VAR circuits 110 are needed for compensating for a ring oscillator.

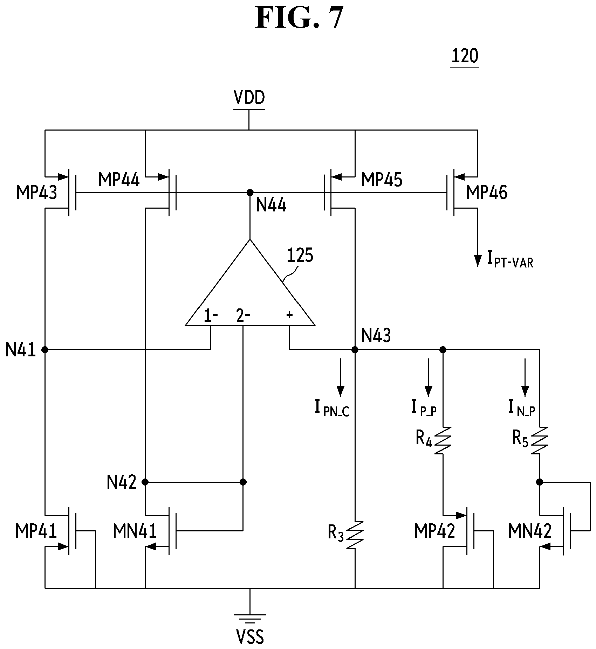

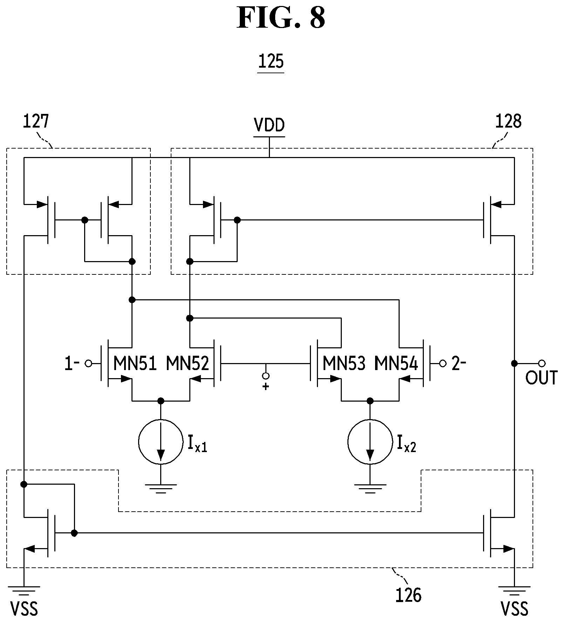

FIG. 7 is a circuit diagram of a PT-VAR circuit 120. FIG. 8 is a circuit diagram of a 3-input amplifier 125 of FIG. 7.

Referring to FIGS. 7 and 8, the PT-VAR circuit 120 may correspond to the PT-VAR circuit 100 of FIG. 5. The PT-VAR circuit 120 may include a 3-input amplifier 125, a pair of NMOS transistors MN41 and MN42, a pair of PMOS transistors MP41 and MP42, a group of PMOS transistors MP43, MP44, MP45, and MP46, and resistors $R_3$, $R_4$, and $R_5$. The NMOS transistors MN41 and MN42 may be connected between a power ground terminal VSS and a node N42, and between the power ground terminal VSS and a node N43, respectively. The NMOS transistors MN41 and MN42 may have their source terminals connected to the power ground terminal VSS, and their drain terminals connected to their gate terminals, forming a diode connection. A gate-source voltage $V_{GSN1}$ may be applied to the gate of the NMOS transistor MN41, and a gate-source voltage $V_{GSN2}$ may be applied to the gate of the NMOS transistor MN42. The PMOS transistors MP41 and MP42 may be connected between the power ground terminal VSS and a node N41, and between the power ground terminal VSS and node N43, respectively. The PMOS transistors MP41 and MP42 may have their drain terminals connected to the power ground terminal VSS, and their drain terminals may be connected to their gate terminals, forming a diode connection. A source voltage $V_{GSP1}$ may be formed at the source terminal of the PMOS transistor MP41, and a source voltage $V_{GSP2}$ may be formed at the source terminal of the PMOS transistor MP42.

The NMOS transistor MN42 may be connected between the power ground terminal VSS and a first terminal (+) of the 3-input amplifier 125, and the NMOS transistor MN41 may be connected between the power ground terminal VSS and a third terminal (2-) of the 3-input amplifier 125. The PMOS transistor MP42 may be connected between the power ground terminal VSS and the first terminal (+) of the 3-input amplifier 125, and the PMOS transistor MP41 may be connected between the power ground terminal VSS and a second terminal (1-) of the 3-input amplifier 125. The resistor $R_4$ may be connected between the PMOS transistor MP42 and the node N43, the resistor $R_5$ may be connected between the NMOS transistor MN42 and the node N43, and the resistor $R_3$ may be connected between the power ground terminal VSS and the node N43.

Referring briefly to FIG. 8, the 3-input amplifier 125 may have the first terminal (+), the second terminal (1-), and the third terminal (2-) as input terminals, and may include current mirrors 126, 127, and 128. The first terminal (+) may be connected to the gate terminals of the NMOS transistors MN52 and MN53, and the second terminal (1-) and the third terminal (2-) may be connected to the gate terminals of the NMOS transistors MN51 and MN54, respectively. A first summed current $I_{x1}$ flowing through the NMOS transistors MN51 and MN52 may satisfy the following equation: $I_{x1} = aI_x$. A second summed current $I_{x2}$ flowing through the NMOS transistors MN53 and MN54 may satisfy the following equation: $I_{x2} = (1 - a)I_x$. Accordingly, a voltage $V_{GSA}$ applied to the first terminal (+) of the 3-input amplifier 125 may satisfy the following equation: $V_{GSA} = aV_{GSP1} + (1 - a)V_{CSN1}$.

The PMOS transistors MP43, MP44, and MP45 may be connected between the node N41 and a power supply terminal VDD, between the node N42 and the power supply terminal VDD, and between the node N43 and the power supply terminal VDD, respectively. The gate terminals of the PMOS transistors MP43, MP44, MP45, and MP46 may be connected to an output node N44 of the 3-input amplifier 125.

Since the source voltage $V_{GSP1}$ of the PMOS transistor MP41 and the gate-drain voltage $_{VGSN1}$ of the NMOS transistor MN41 have a negative coefficient in the temperature-voltage relationship, a current IPN_C flowing through the resistor R3 may be expressed as shown in Equation 5. The current IPN_C may be a CTAT current with a negative coefficient relative to temperature, based on NMOS and PMOS transistors.

[Equation 5]

$$I_{PN\_C} = (aV_{GSP1} + (1 - a)V_{GSN1})/R_3$$

Similarly, as already mentioned above, PTAT characteristics proportional to the absolute temperature T may be created due to the temperature characteristic differences caused by the size differences between the PMOS transistor MP41, the NMOS transistor MN41, and the PMOS transistor MP42. Additionally, the PTAT characteristics proportional to absolute temperature T may also be created due to the temperature characteristic differences caused by the size differences between the PMOS transistor MP41, the NMOS transistor MN41, and the NMOS transistor MN42. Therefore, a current IP_P flowing through the resistor R4 may be expressed as shown in Equation 6 and may be a PMOS transistor-based PTAT current proportional to the absolute temperature T. Furthermore, a current IN_P flowing through the resistor R5 may be expressed as shown in Equation 7 and may be an NMOS transistor-based PTAT current proportional to the absolute temperature T.

[Equation 6]

$$I_{P\_P} = (aV_{GSP1} + (1 - a)V_{GSN1} - V_{GSP2})/R_4$$

[Equation 7]

$$I_{N\_P} = (aV_{GSP1} + (1 - a)V_{GSN1} - V_{GSN2})/R_5$$

In Equations 6 and 7, *a* represents a weighting factor.

A compensation current IPT-VAR flowing through the PMOS transistor MP46 may be equal to the sum of the CTAT current IPN_C and the PTAT currents IP_P and IN_P, as shown in Equation 8.

[Equation 8]

$$I_{PT-VAR} = I_{PN\_C} + I_{P\_P} + I_{N\_P}$$

A PLL circuit may include at least one PMOS transistor and at least one NMOS transistor and may thus be influenced by both the corresponding PMOS transistor process and the corresponding NMOS transistor process. In some example embodiments, even if the PLL circuit is affected by both the PMOS transistor process and the NMOS transistor process, the PT-VAR circuit 120 may compensate for both NMOS process variations and PMOS process variations by adjusting the weighting factor a. In this case, the PT-VAR circuit 120 may adjust the weighting factor a by controlling the transconductance of the 3-input amplifier 125. For example, the weighting factor a may be adjusted by controlling the transconductance of the NMOS transistors MN51, MN52, MN53, and MN54 in FIG. 8. Additionally, the PT-VAR circuit 120 may output a current that is independent of temperature changes by adjusting the ratio of the resistors R3, R4, and R5.

In some example embodiments, the compensation current IPT-VAR generated by the PT-VAR circuit 120 may vary depending on PVT variations. The compensation current IPT-VAR may reflect changes due to the PMOS transistor process, the NMOS transistor process, temperature changes, power supply voltage changes, or power supply voltage noise. The compensation current IPT-VAR may vary in accordance with PVT variations in the same or similar environmental conditions affecting other components included in the PLL circuit, such as a reference current generation circuit 10, current DACs 20, or a VCO 30.

In some example embodiments, the PT-VAR circuit 120 may generate a compensation current IPT-VAR that is relatively less affected by PVT variations by adjusting the weighting factor a and the ratio of the resistors R3, R4, and R5 in consideration of PVT variations. The reference current generation circuit 10 may generate a reference current IUNIT based on the compensation current IPT-VAR. As a result, a PLL circuit that may be relatively less affected by PVT variations can be designed using a relatively smaller number of IDAC circuits.

In some example embodiments, compared to a configuration where a PT-VAR circuit designed with NMOS transistors and another PT-VAR circuit designed with PMOS transistors are used together to generate a compensation current, the PT-VAR circuit 120 may reduce the area occupied within the PLL circuit. Additionally, using only a single 3-input amplifier may reduce power consumption. Therefore, the PLL circuit may be relatively less affected by PVT variations, may have improved reliability, may occupy a relatively smaller area, and a relatively lower power consumption maybe obtained.

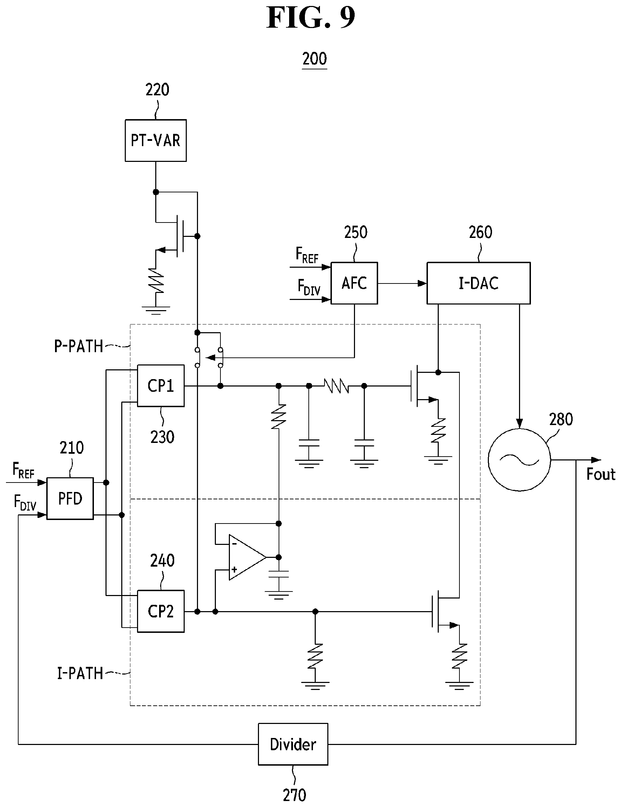

FIG. 9 is a circuit diagram of a PLL circuit including the PT-VAR circuit of FIG. 7.

Referring to FIG. 9, a PLL circuit 200 may include a phase frequency detector ("PFD") 210, a first charge pump ("CP1") 230, a second charge pump ("CP2") 240, a PT-VAR circuit 220 (e.g., corresponding to the PT-VAR circuit 120 of FIG. 7), a frequency calibration circuit ("AFC") 250, a current DAC ("I-DAC") circuit 260, a VCO 280, and a divider circuit ("Divider") 270. The PLL circuit 200 may compare a divided signal $F_{DIV}$ generated based on an output signal $F_{OUT}$ from the VCO 280 with a reference signal $F_{REF}$, lock the phase of the VCO 280, and generate an output signal $F_{OUT}$ of the target frequency of the VCO 280. The PLL circuit 200 may be formed with a dual-loop structure (P-PATH and I-PATH) to reduce or minimize noise caused by the resistance of the loop filter and to reduce the capacitor size of the loop filter.

The phase frequency detector 210 may compare the reference signal $F_{REF}$ and the divided signal $F_{DIV}$ and generate a detection signal, which may be a pulse signal representing the phase difference between the reference signal $F_{REF}$ and the divided signal $F_{DIV}$. The first and second charge pumps 230 and 240 may receive the detection signal and charge or discharge the loop filter based on the detection signal. The loop filter may provide a control current, which may vary according to the amount of charge stored in capacitors, to the current DAC circuit 260. The current DAC circuit 260 may convert the received control current into a reference current according to the number of current DACs that may be turned on and provide the reference current to the VCO 280. The divider circuit 270 may divide the output signal $F_{OUT}$ and provide it to the phase frequency detector 210 and the frequency calibration circuit 250. The VCO 280 may generate an output signal $F_{OUT}$ with an adjusted frequency according to the received reference current. The frequency calibration circuit 250 may generate a target signal for adjusting the frequency of the output signal $F_{OUT}$ based on the reference signal $F_{REF}$ and the divided signal $F_{DIV}$, and provide it to the current DAC circuit 260. While the frequency calibration circuit 250 is operating, the PT-VAR circuit 100 may be connected to the output terminals of the first and second charge pumps 230 and 240. When the operation of the frequency calibration circuit 250 is complete, the connection between the PT-VAR circuit 220 and the output terminals of the first and second charge pumps 230 and 240 may be disconnected.

In some example embodiments, the PT-VAR circuit 220 may generate a compensation current that may compensate for PVT variations in the PLL circuit 200 by adjusting the transconductance and resistance ratio of an internal 3-input amplifier in consideration of or based on PVT variations in the PLL circuit 200, and provide the compensation current to the PLL circuit 200.

As described herein, any devices, systems, modules, portions, units, controllers, circuits, and/or portions thereof according to any of the example embodiments, and/or any portions thereof (including, without limitation, the phase frequency detector ("PFD") 210, the first charge pump ("CP1") 230, the second charge pump ("CP2") 240, the frequency calibration circuit ("AFC") 250, the current DAC ("I-DAC") circuit 260, the divider circuit ("Divider") 270, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While several embodiments have been provided in the present disclosure, it should be understood that the disclosed systems and methods might be embodied in many other specific forms without departing from the scope of the present disclosure. The present examples are to be considered as illustrative and not restrictive, and the intention is not to be limited to the details given herein. For example, the various elements or components may be combined or integrated in another system or certain features may be omitted, or not implemented.

**Claims**

1. A phase-locked loop, PLL, circuit comprising:

   a reference current generation circuit (10) including a PT-VAR circuit (120), the PT-VAR circuit being configured to generate a compensation current to compensate for at least one of process variations, temperature changes, and power supply voltage changes in the PLL circuit (1), and the reference current generation circuit (10) being configured to output the compensation current as a reference current;
   a current DAC circuit (20) configured to convert the reference current into a control current based on a digital code; and
   a voltage-controlled oscillator, VCO, (30) configured to generate a signal based on the control current,

   wherein the compensation current is a sum of a first compensation current based on PMOS and NMOS (MP, MN) transistors and having a complementary-to-absolute temperature, CTAT, characteristic, a second compensation current based on a PMOS transistor and having a proportional-to-absolute temperature, PTAT, characteristic, and a third compensation current based on an NMOS transistor and having a PTAT characteristic.

2. The PLL circuit of claim 1, wherein
   the PT-VAR circuit (120) includes:

   a 3-input amplifier (125) including a first input terminal, a second input terminal, and a third input terminal;
   a first PMOS transistor (MP41) connected as a diode between the first input terminal (1-) and a power ground terminal (VSS);
   a first NMOS transistor (MN41) connected as a diode between the second input terminal (2-) and the power ground terminal (VSS); and
   a resistor ($R_3$) connected between the third input terminal (+) and the power ground terminal (VSS),

   wherein the first compensation current (IPN.C) is a current flowing through the resistor ($R_3$).

3. The PLL circuit of claim 2, wherein a third voltage is generated at the second input terminal (2-), wherein the third voltage is a weighted average of a first voltage that is a source voltage of the first PMOS transistor (MP41) formed at the first input terminal (1-) and a second voltage that is a gate-drain voltage of the first NMOS transistor (MN41) formed at the second input terminal (2-), optionally wherein the third voltage is a sum of the first voltage weighted by a first weighting factor and the second voltage weighted by a second weighting factor.

4. The PLL circuit of claim 1, 2 or 3, wherein
   the PT-VAR circuit (120) includes:

   a 3-input amplifier (125) including a first input terminal (1-), a second input terminal (2-), and a third input terminal (+);

a first PMOS transistor (MP41) connected as a diode between the first input terminal (1-) and a power ground terminal (VSS);

a first NMOS transistor (MN41) connected as a diode between the second input terminal (2-) and the power ground terminal;

a second PMOS transistor (MP42) connected as a diode between the third input terminal (+) and the power ground terminal (VSS) and having a size larger than the first PMOS transistor (MP41); and

a resistor ($R_4$) connected between the second PMOS transistor (MP42) and the power ground terminal,

wherein the second compensation current ($I_{p\_p}$) is a current flowing through the resistor ($R_4$).

5. The PLL circuit of claim 1, wherein
the PT-VAR circuit (120) includes:

a 3-input amplifier (125) including a first input terminal (1-), a second input terminal (2-), and a third input terminal (+);

a first PMOS transistor (MP41) connected as a diode between the first input terminal (1-) and a power ground terminal (VSS);

a first NMOS transistor (MN41) connected as a diode between the second input terminal (2-) and the power ground terminal (VSS);

a second NMOS transistor (MN42) connected as a diode between the third input terminal(+) and the power ground terminal and having a larger size than the first NMOS transistor (MN41); and

a resistor ($R_5$) connected between the second NMOS transistor (MN42) and the power ground terminal,

wherein the third compensation current is a current flowing through the resistor ($R_5$).

6. The PLL circuit of claim 5, wherein

a third voltage is generated at the third input terminal (+), wherein the third voltage is a weighted average of a first voltage that is a source voltage of the first PMOS transistor (MP41) formed at the first input terminal (1-) and a second voltage that is a gate-drain voltage of the first NMOS transistor (MN41) formed at the second input terminal (2-), and

the third compensation current ($I_{N\_P}$) is generated based on a voltage difference between the third voltage and a fourth voltage that is a gate-drain voltage of the second NMOS transistor (MN42).

7. A phase-locked loop, PLL, circuit comprising:

a reference current generation circuit (10) including a PT-VAR circuit (120), the PT-VAR circuit being configured to generate a compensation current to compensate for at least one of process variations, temperature changes, and power supply voltage changes in the PLL circuit (1), and the reference current generation circuit (10) being configured to output the compensation current as a reference current;

a current DAC circuit (20) configured to convert the reference current into a control current based on a digital code; and

a voltage-controlled oscillator, VCO, (30) configured to generate a signal based on the control current,

wherein the PT-VAR circuit (120) includes:

a 3-input amplifier (125) including a first input terminal (1-), a second input terminal (2-), and a third input terminal (+);

a first PMOS transistor (MP41) connected as a diode between the first input terminal and a power ground terminal (VSS);

a first NMOS transistor (MN41) connected as a diode between the second input terminal and the power ground terminal;

a first resistor ($R_3$) connected between the third input terminal (+) and the power ground terminal;

a second PMOS transistor (MP42) connected as a diode between the third input terminal (+) and the power ground terminal (VSS) and having a size larger than the first PMOS transistor (MP41);

a second resistor ($R_4$) connected between the third input terminal (+) and the second PMOS transistor (MP42);

a second NMOS transistor (MN42) connected as a diode between the third input terminal (+) and the power ground terminal (VSS) and having a size larger than the first NMOS transistor (MN41); and

a third resistor ($R_5$) connected between the third input terminal (+) and the second NMOS transistor (MN42).

8. The PLL circuit of claim 7, wherein

the 3-input amplifier (125) includes first, second ,third, and fourth amplifier transistors (MN51, MN52, MN53, MN54),
the first input terminal (1-) is connected to a gate terminal of the first amplifier transistor (MN51),
the second input terminal (2-) is connected to a gate terminal of the fourth amplifier transistor (MN54), and
the third input terminal (+) is connected to gate terminals of the second and third amplifier transistors (MN52, MN53).

9. The PLL circuit of any one of claims 7 to 8, wherein
the PT-VAR circuit (120) further includes:

a third PMOS transistor (MP43) connected between a power supply terminal (VDD) and a source terminal of the first PMOS transistor (MP41);
a fourth PMOS transistor (MP44) connected between the power supply terminal and a gate-drain terminal of the first NMOS transistor (MN41); and
a fifth PMOS transistor (MP45) connected between the power supply terminal and the first resistor ($R_3$),

wherein an output terminal of the 3-input amplifier (125) is connected to gate terminals of the third, fourth, and fifth PMOS transistors.

10. A phase-locked loop, PLL circuit comprising:

a PT-VAR circuit (120) configured to generate a compensation current that compensates for at least one of process variations, temperature changes, and power supply voltage changes in the PLL circuit (1), wherein the PT-VAR circuit includes:

a 3-input amplifier (125) including a first input terminal (1-), a second input terminal (2-), and a third input terminal (+);
a first PMOS transistor (MP41) connected as a diode between the first input terminal (1-) and a power ground terminal (VSS);
a first NMOS transistor (MN41) connected as a diode between the second input terminal (2-) and the power ground terminal;
a first resistor ($R_3$) connected between the third input terminal (+) and the power ground terminal (VSS);
a second PMOS transistor (MP42) connected as a diode between the third input (+) terminal and the power ground terminal; and
a second NMOS transistor (MN42) connected as a diode between the third input (+) terminal and the power ground terminal (VSS), wherein
the compensation current is a sum of a first compensation current ($I_{PN\_C}$) flowing through the first resistor ($R_3$) and having a complementary-to-absolute temperature, CTAT, characteristic, a second compensation current ($T_{P\_P}$) flowing through the second PMOS transistor (MP42) and having a proportional-to-absolute temperature, PTAT, characteristic, and a third compensation current ($I_{N\_P}$) flowing through the second NMOS transistor (MN42) and having a PTAT characteristic.

11. The PLL circuit of claim 10, wherein a third voltage is generated at the third input terminal (+), wherein the third voltage is a weighted average of a first voltage that is a source voltage of the first PMOS transistor formed at the first input terminal and a second voltage that is a gate-drain voltage of the first NMOS transistor (MN41) formed at the second input terminal (2-), optionally wherein the third voltage is a sum of the first voltage weighted by a first weighting factor and the second voltage weighted by a second weighting factor.

12. The PLL circuit of claim 5, 10 or 11, wherein

a third voltage is generated at the third input terminal (+), wherein the third voltage is a weighted average of a first voltage that is a source voltage of the first PMOS transistor (MP41) formed at the first input terminal (1-) and a second voltage that is a gate-drain voltage of the first NMOS transistor (MN41) formed at the second input terminal (2-), and optionally,

the second compensation current is generated based on a voltage difference between the third voltage and a fourth voltage that is a source voltage of the second PMOS transistor (MP42).

13. The PLL circuit of claim 10, 11 or 12, wherein the second PMOS transistor (MP42) has a larger size larger than the first PMOS transistor (MP41), and further includes a second resistor ($R_4$) connected between the third input terminal (+) and the second PMOS transistor (MP42), and/ or, wherein the second NMOS transistor (MN42) has a larger size larger than the first NMOS transistor (MN41), and further includes a second resistor ($R_5$) connected between the third input terminal (+) and the second NMOS transistor (MN42).

# FIG. 1

# FIG. 2

<u>32</u>

VDD

MP31    MP32

IN+    IN-

OUT-    OUT+

MN31 MN32    MN33 MN34

VSS

# FIG. 3

## FIG. 4

# FIG. 5

# FIG. 6

110

# FIG. 7

# FIG. 8

<u>125</u>

# FIG. 9

Europäisches
Patentamt
European
Patent Office
Office européen
des brevets

# EUROPEAN SEARCH REPORT

**Application Number**

EP 25 18 4570

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/106441 A1 (LEE KYUNG MIN [KR] ET AL) 28 March 2024 (2024-03-28) | 1 | INV. H03L7/08 |
| A | * paragraph [0019] - paragraph [0088]; figures 1-8 * | 2-13 | H03L7/089 H03L7/099 |
| A | US 2020/169221 A1 (CAI LI [SG] ET AL) 28 May 2020 (2020-05-28) * paragraph [0041] - paragraph [0075]; figures 5,6, 15 * | 1-13 | |
| A | US 2015/137896 A1 (GAJDA BARTOSZ [NO]) 21 May 2015 (2015-05-21) * paragraph [0012] - paragraph [0029]; figures 1-3 * | 1-13 | |

**TECHNICAL FIELDS SEARCHED (IPC)**

H03L

The present search report has been drawn up for all claims

| Place of search | Date of completion of the search | Examiner |
|---|---|---|
| The Hague | 14 November 2025 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 4570

This annex lists the patent family members relating to the patent documents cited in the above-mentioned European search report.
The members are as contained in the European Patent Office EDP file on
The European Patent Office is in no way liable for these particulars which are merely given for the purpose of information.

14-11-2025

| Patent document cited in search report | Publication date | Patent family member(s) | Publication date |
|---|---|---|---|
| US 2024106441 A1 | 28-03-2024 | NONE | |
| US 2020169221 A1 | 28-05-2020 | CN 111224619 A | 02-06-2020 |
| | | CN 210839475 U | 23-06-2020 |
| | | US 2020169221 A1 | 28-05-2020 |
| US 2015137896 A1 | 21-05-2015 | NONE | |

EPO FORM P0459

For more details about this annex : see Official Journal of the European Patent Office, No. 12/82